# EUROPEAN PATENT APPLICATION

(11) **EP 4 249 973 A1**
(43) Date of publication of application: **27.09.2023**
(21) Application number: 22164447.9
(22) Date of filing: 25.03.2022
(51) Int. Cl.: G02B 6/42, H01R 12/71, H01R 13/6583, H01R 25/00, H01R 27/00, H05K 9/00

(54) **PLUGGABLE MODULE CAGE ASSEMBLY**

(71) Applicant: Nokia Solutions and Networks Oy, 02610 Espoo (FI)
(72) Inventor: van den Berg, Eric Jozef Diane, 2560 Nijlen (BE); De Boeck, Jan, 3271 Zichem (BE); Verbeke, Kjell, 9140 Temse (BE); Talal, Habib, Ontario, K1E2X2 (CA); Bauwens, Stan, 9160 Lokeren (BE); Walklin, Sheldon, Ottawa, K2S2A6 (CA)
(74) Representative: IP HILLS NV

(57) **Abstract**

Example embodiments describe a pluggable module cage assembly for telecommunication and/or data systems, the cage assembly comprising a cage chamber configured to receive a pluggable module of a first type, a removable wall configured to subdivide said cage chamber into two laterally adjacent sub-chambers, at least one of said sub-chambers being configured to receive a pluggable module of a second type, at least one connector configured to provide an electrical connection to the pluggable module of the first type when received in the cage chamber or to the pluggable module of the second type when received in the at least one of said sub-chambers.

## Description

### Technical Field

Various example embodiments relate to pluggable module cage assemblies.

### Background

In telecommunications and/or data systems, such as for example in passive optical network (PON) systems, optical fibre cabling connects an end user to an internet service provider (ISP) to deliver for example broadband internet. Such a PON system generally includes cage systems each configured to receive one or more pluggable optical modules, in particular pluggable transceiver modules. Size and shape of said pluggable optical modules as well as of the ports of the cage systems have been defined by international standards in so-called Multi-Source Agreements (MSA). Different MSA exist for various optical transceiver modules, such as for example for gigabit interface converter (GBIC), 10 gigabit small form-factor pluggable (XFP), C form-factor pluggable (CFP), CFP2, CXP, CPAK, Quad Small Form-Factor Pluggable (QSFP), QSFP+, QSFP28, QSFP-DD, micro-QSFP, Small Formfactor Pluggable (SFP), SFP+, SFP28, SFP-Double Density (SFP-DD), DSFP. SFP was respecified up to 2.5 Gbps (Gigabit per second). SFP+ and SFP28 include the same mechanical form factor but go up to 10Gbps and 28Gbps respectively. SFP-DD is a longer form factor in which a number of electrical connections has been increased from 20 to 40. SFP-DD-112 is still under development and should reach 112 Gbps. The cage systems configured to receive said optical transceiver modules all include a cage body mounted on a base plate including a printed circuit board (PCB). The cage body includes a port opening configured to receive said pluggable optical module. The system further comprises a connector configured to operatively connect said pluggable optical module to the PCB.

Instead of having a cage system including a cage body, shaped and sized according to one of said MSA standards, it is also known to have "double wide" cage systems, of which a cage body is configured to receive either a single "double wide" optical module or two "single width" modules according to MSA standards. Such a "double wide" cage system can include a removable wall which can be inserted into the cage body to subdivide an optical module receiving space of the cage body into two subspaces, each configured to receive a "single width" optical module. When mounted into the cage body, the removable wall can then provide EMI (ElectroMagnetic Interference) shielding to the two subspaces.

### Summary

The scope of protection sought for various embodiments of the invention is set out by the independent claims.

The embodiments and features described in this specification that do not fall within the scope of the independent claims, if any, are to be interpreted as examples useful for understanding various embodiments of the invention.

Amongst others, it is an object of embodiments of the invention to provide an EMI compliant cage and cage assembly which can be backward compatible with standard "single width" optical modules and which can receive (future) pluggable optical modules which may be wider than actual standards.

This object is achieved, according to a first example aspect of the present disclosure, by a pluggable module cage assembly for telecommunication and/or data systems as defined by claim 1, the cage assembly comprising a cage chamber configured to receive a pluggable module of a first type, a removable wall configured to subdivide said cage chamber into two laterally adjacent sub-chambers, at least one of said sub-chambers being configured to receive a pluggable module of a second type, at least one connector configured to provide an electrical connection to the pluggable module of the first type when received in the cage chamber or to the pluggable module of the second type when received in the at least one of said sub-chambers, and means for biasing the pluggable module of the second type away from said at least one connector when the pluggable module of the second type is inserted into the cage chamber.

Such a pluggable module cage assembly can be used for pluggable modules of different widths thanks to the removable wall. In absence of the removable wall in the cage chamber, the cage chamber can receive a pluggable module of a first type, in particular of a first width, having a relatively large width, in particular having a width substantially spanning an internal width of the cage chamber. When the removable wall is mounted into the cage chamber, the cage chamber is subdivided into two laterally adjacent sub-chambers, of which at least one sub-chamber is configured to receive a pluggable module of a second type, in particular of a second width, the second width being smaller than the first width, for example a standard single-width pluggable optical module. In that case of use, the removable wall is configured to provide EMI shielding preventing EMI leakage around the pluggable module received in the sub-chamber. To prevent use of the cage assembly with a pluggable module of the second type, for example, a standard single-width pluggable optical module, in absence of the removable wall, the present pluggable cage module further includes means for biasing a pluggable module, in particular of the second type, away from said at least one connector when the pluggable module, in particular of the second type, is inserted into the cage chamber. Such biasing means can prevent correct insertion, in particular correct connection with the connector, of a pluggable module into the cage chamber in absence of the removable wall in case a width of the pluggable module is smaller than an internal width of the cage chamber. When a width of the pluggable module corresponds to an internal width of the cage chamber, side walls of the pluggable module can overcome the biasing force of the biasing means such that the pluggable module, in particular of the first type, can be inserted into the cage chamber and connected to the at least one connector. When a width of the pluggable module is smaller than the internal width of the cage chamber, for example for a pluggable module of the second type, the biasing force of the biasing means on the pluggable module during insertion of said pluggable module into the cage chamber, is such that the biasing force can only be overcome by the presence of the removable wall in the cage chamber at insertion of the pluggable module. The removable wall can exert a counterforce on the pluggable module, in particular of the second type, overcoming the biasing force of the means for biasing the pluggable module away from the connector. In absence of the removable wall, the biasing force of the means for biasing the pluggable module away from the connector cannot be overcome for a pluggable module of the second type having a width which is smaller than an internal width of the cage chamber. As such, the cage assembly is secured against improper use of the cage assembly, in particular against use of the cage assembly with a pluggable module having a width which is smaller than an internal width of the cage chamber in absence of the removable wall in the cage chamber, which would cause unwanted EMI leakage. Alternatively, the removable wall may be configured to subdivide said cage chamber into two vertically adjacent sub-chambers, such that the cage assembly can be used with pluggable modules of different heights instead of different widths.

According to example embodiments, an internal side wall of said cage chamber may include said biasing means. Said biasing means may for example be mounted onto an internal side wall of said cage chamber. Alternatively, said biasing means may form an integral part of an internal side wall of said cage chamber. A side wall of the cage chamber is to be understood as a wall forming a side of the cage chamber in normal positioning in use, contrary to a top wall, a bottom wall or a back wall, the front side of the cage chamber being open. The side wall is substantially in parallel with a direction of insertion of the pluggable module into the cage chamber. Such a positioning of the biasing means can allow the biasing means to provide a biasing force which is substantially transversal to said internal side wall of the cage chamber. In this way, the means can bias a pluggable module away laterally from said at least one connector when the pluggable module is inserted into the cage chamber. Alternatively, the biasing means may be mounted to other internal walls of the cage.

According to further example embodiments, said biasing means can include a leaf spring. A leaf spring can be manufactured relatively easily while allowing to provide a biasing force which can be sufficiently strong to prevent insertion of the pluggable module, in particular of the second type, into the cage chamber in absence of the removable wall. Additionally, due to its relatively simple shape, a leaf spring can be oriented in such a way that insertion itself of a pluggable module into the cage chamber can cause a gradual compressing of the leaf spring against the biasing force. As such, the leaf spring can combine a biasing effect on the pluggable module with a relatively easy insertion of the pluggable module into the cage chamber.

According to further example embodiments, a length of said removable wall can be shorter than a depth of the cage chamber. A length of the removable wall can for example be such that the removable wall extends over substantially half, or over substantially two thirds, or over substantially three quarters of a depth of the cage chamber, or over any other suitable length, as long as a length of said removable wall is sufficient to provide a counterforce to the biasing force of the means for biasing when a pluggable module of the correct width is inserted into the at least one sub-chamber. Even when said removable wall does not extend over an entire depth of the cage chamber, the wall is still considered to subdivide said cage chamber into two sub-chambers. When a length of said removable wall is shorter than a depth of the cage chamber, the removable wall can still be removed relatively easily, even when a heatsink pushes down on the cage chamber, while still providing sufficient EMI shielding.

According to further example embodiments, said removable wall may be mounted to a removable inner frame. The removable inner frame is configured to be at least partially insertable into the cage chamber and is configured to provide EMI shielding. A depth of the removable inner frame may be substantially shorter than a depth of the cage chamber or than a length of the removable wall. The removable wall may be mounted to the removable inner frame in a fixed or releasable way.

According to further example embodiments, dimensions of the removable wall may be such that the removable wall is held in the cage chamber by friction. A friction fit of the removable wall in the cage chamber can avoid the need for additional means for securing the removable wall in the cage chamber and can prevent an accidental loss of the wall from the cage chamber, for example caused by vibration. Thereto, an internal side of a top wall and/or of a bottom wall of the cage chamber may include one of a groove and a tongue which may fit into the other of a corresponding groove and the tongue included in the removable wall. Other example embodiments of friction fits are possible as well. In particular, in case the removable wall is mounted to a removable inner frame, dimensions of the removable inner frame may be such that the removable inner frame, and thus also the removable wall mounted to the frame, is held in the cage chamber by friction. Alternatively, the cage assembly can include operable means for fastening the removable wall in the cage chamber, such as for example a bail latch, screws, notches or any other fastening means known to the person skilled in the art.

Sample embodiments of the pluggable module cage assembly, as defined by claim 7, can further comprise means for storing said removable wall. As an example, an exterior wall of the pluggable module cage chamber, for example a side wall, can include an additional wall at a distance of the exterior wall to form a slit between said exterior wall and said additional wall, into which the removable wall can be stored. Other example embodiments are possible as well. Such a means for storing the wall can improve ease of use of the pluggable module cage assembly, in that pluggable modules of different widths can be exchanged, while the removable wall can be stored relatively easily and safely when not mounted in the cage chamber.

For example, the pluggable module cage assembly may be configured to receive a "double wide" pluggable optical module. A "double wide" pluggable optical module has a length and a height which is substantially equal to a standard single width pluggable optical module but has a width which is substantially double of a width of said standard single width pluggable optical module. An internal width of the cage chamber in absence of the removable wall may correspond to a width of the "double wide" pluggable optical module. The cage assembly may include a set of two connectors which are spaced apart in such a way that the "double wide" pluggable optical module is configured to connect to the set of two connectors simultaneously. Alternatively, an internal width of the cage chamber may even be larger than a width of the "double wide" pluggable optical module. Alternatively, an internal width of the cage chamber may be larger than a width of a standard single width pluggable optical module but still smaller than a width of a "double wide" pluggable optical module. In this way, the cage assembly may be configured to receive (future or next generation) pluggable modules which may be larger than actual standards, thus providing more space for additional components, while still remaining backward compatible with actual MSA standards when mounting the removable wall in the cage chamber.

According to further example embodiments, each of said two laterally adjacent sub-chambers may be configured to receive a pluggable module. The cage assembly can for example include two connectors, one in each sub-chamber, which are each configured to provide an electrical connection to the pluggable module when received in the cage sub-chambers. In this way, the pluggable module cage chamber can either receive a "double wide" pluggable module when the removable wall is absent from the cage chamber, or any other type of pluggable module having a width corresponding to an internal width of the cage chamber. Or the pluggable module cage chamber can receive two pluggable modules simultaneously, for example two standard single width pluggable modules, each received in one of the laterally adjacent sub-chambers when the removable wall is mounted in the cage chamber. Again, this can improve backward compatibility of the pluggable module cage assembly.

According to further example embodiments, the pluggable module cage assembly may then further comprise at least two connectors. The at least two connectors may be laterally spaced apart. The at least two connectors may each be configured to provide an electrical connection to one of two separate pluggable modules, in particular of the second type, when received into the cage chamber, for example to two standard single width pluggable modules when received in the cage chamber, in particular when received in the sub-chambers when the removable wall is mounted into the cage chamber. Additionally, and/or alternatively, the at least two connectors may be configured to provide an electrical connection to a single pluggable module simultaneously, for example to a pluggable module, in particular of the first type, having a width which is larger than a width of a standard single width pluggable module.

Additionally, said at least two connectors may then form an integral piece. An integral one-piece connector including two connectors can be advantageous in particular in case of use of the cage assembly with a single pluggable module, in particular of the first type, configured to be connected to two connectors. In that case, any spatial play between the two connectors might be detrimental to a connection of the pluggable module with the two connectors simultaneously. By providing two connectors in an integral single piece, a distance between the two connectors can be kept substantially constant or at least within acceptable tolerance. Such a one-piece connector including two connectors for use in a pluggable module cage assembly can be considered as an invention on its own.

Sample embodiments of the pluggable module cage assembly, as defined by claim 12, can further comprise means for sensing a presence of the removable wall mounted within the cage chamber. In absence of the removable wall in the cage chamber, a means for sensing a presence of the removable wall can additionally be configured to provide a visual and/or auditory warning signal, sign, tone or light to a user of the pluggable cage assembly. Such a warning signal can for example be transmitted through a network management system. This can provide an additional and/or alternative warning to the user such that the cage assembly is not used without the removable wall in case a pluggable module inserted into the cage chamber has a width which is smaller than an internal width of the cage chamber. Such a sensing means could be used in a cage assembly without the biasing means as a first warning to the user in absence of the removable wall but would still not be sufficient to prevent misuse of the cage assembly, as is the case for the biasing means.

According to further example embodiments, the pluggable module cage assembly can further comprise means for mounting said cage chamber onto a base plate. Said mounting means can for example include a plurality of pins spaced apart along a circumference of a bottom side of the cage chamber so as to leave a relatively large area free which may be suitable for Surface Mount Devices (SMD) components. The pins can for example be Dry Press Fit (DPF) pins or Pin Through Hole (PTH) solder pins or any other suitable mounting means known to the person skilled in the art.

Additionally, at least one of said mounting means may be positioned on a bottom side of said cage chamber spaced apart from an outer edge or a circumference of the cage chamber. Said at least one mounting means can for example be positioned on a centre line of a bottom side of the cage chamber or elsewhere. Said at least one mounting means can be configured to prevent the bottom side of the cage chamber to bend upwards.

According to further example embodiments, the pluggable cage assembly can further comprise a base plate including a printed circuit board (PCB), the pluggable module cage being mounted onto the base plate such that the at least one connector of the cage is in electrical connection with the PCB. Such a pluggable cage assembly can provide one or more of the above-mentioned advantages.

According to further example embodiments, the pluggable module cage assembly may then further comprise a gasket mounted to a front side of the pluggable module cage chamber and configured to minimize EMI. The gasket can for example include a plurality of finger springs configured to provide EMI shielding around a front opening of the cage chamber through which an pluggable module is configured to be received.

### Brief Description of the Drawings

Some example embodiments will now be described with reference to the accompanying drawings.
Fig. 1a and 1b show a schematic top view of an example embodiment of a pluggable module cage assembly;
Fig. 2a and 2b show the example embodiment of Figures 1a and 1b when a pluggable module is received;
Fig. 3a and 3b show the example embodiment of Figures 1a and 1b when a single width pluggable module is received;
Fig. 4 shows a schematic top view of another example embodiment of a pluggable module cage assembly;
Fig. 5a shows a schematic top view of a further example embodiment of a pluggable module cage assembly including an integral connector, of which a perspective view is shown in Fig. 5b;
Fig. 6a and 6b show a schematic top view of another example embodiment of a pluggable module cage assembly;
Fig. 7a and 7b show the example embodiment of Figures 6a and 6b when a pluggable module is received;
Fig. 8 shows a perspective top view of a further example embodiment of a pluggable module cage assembly;
Fig. 9 shows a perspective bottom view of the example embodiment of Fig. 8; and
Fig. 10 shows a perspective top view of a further example embodiment of a pluggable module cage assembly.

### Detailed Description of Embodiment(s)

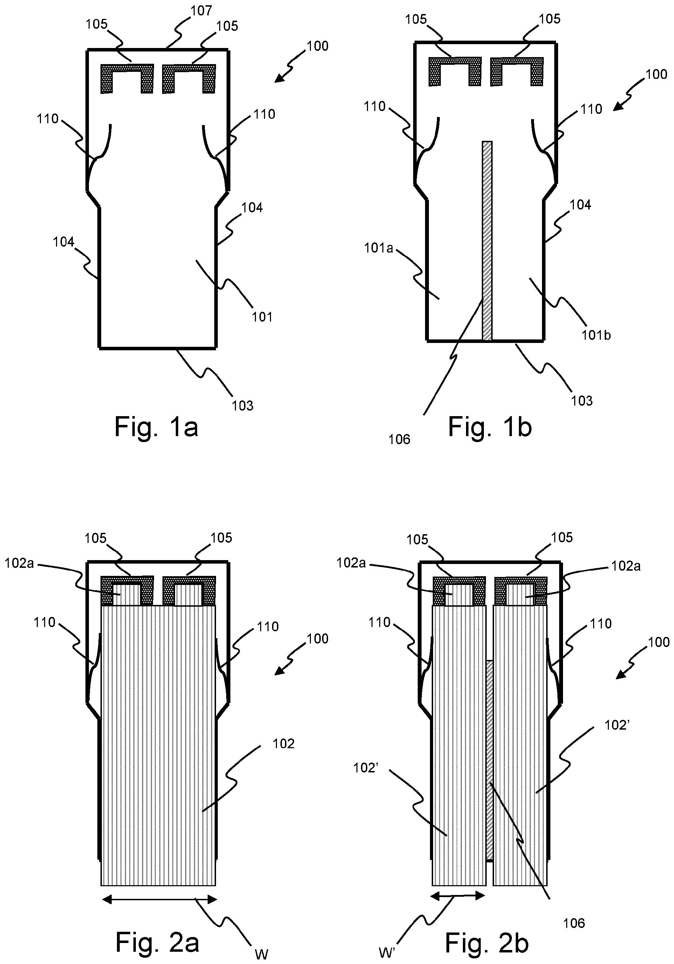

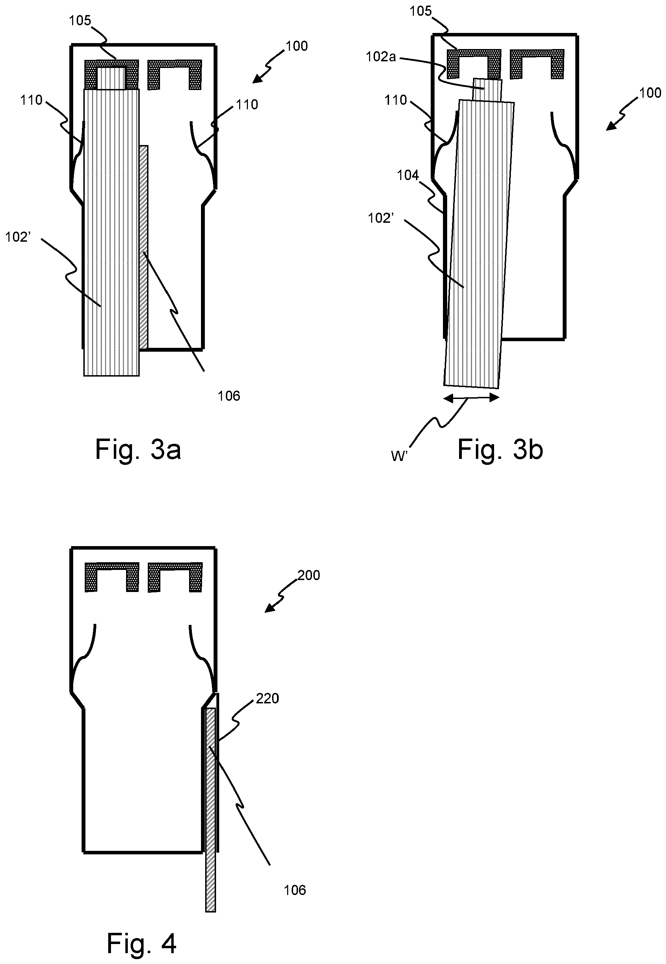

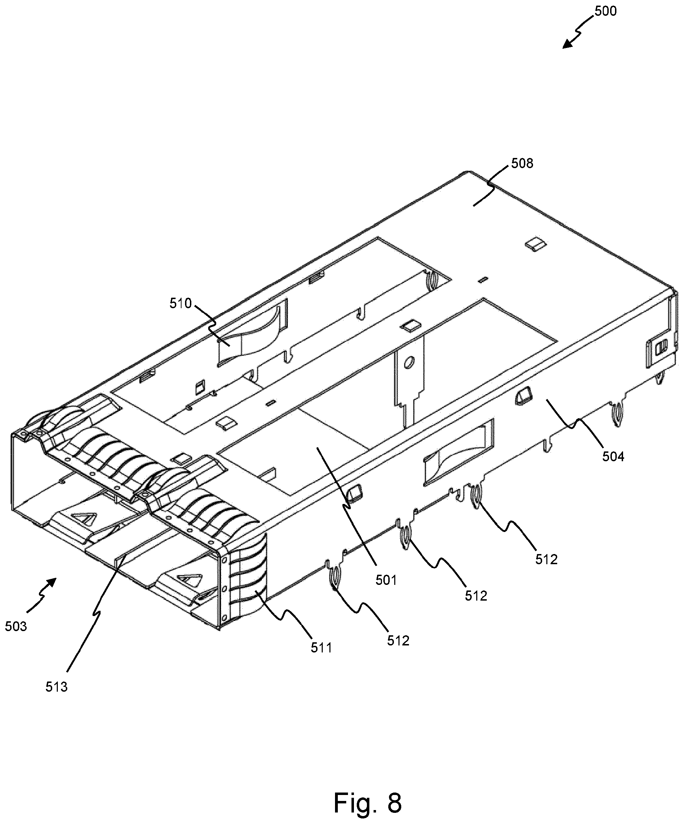

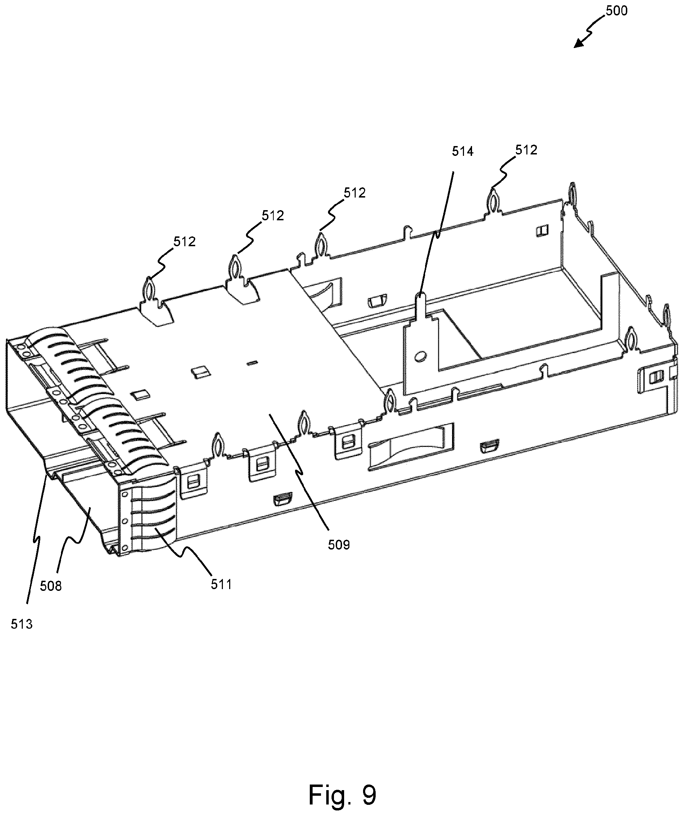

Fig. 1a and 1b show a schematic top view of an example embodiment of a pluggable module cage assembly 100. The pluggable module cage assembly 100 comprises a cage chamber 101 configured to receive a pluggable module 102, 102', as shown in Figures 2a and 2b. The cage chamber 101 can include a front side 103 including an opening configured to receive a pluggable module 102. The cage chamber 101 can further include two side walls 104 with respect to the front side 103. The side walls do not include a top wall or bottom wall, as shown in Figures 8 or 9. The cage assembly 100 further comprises at least one connector 105, for example two connectors, which are each configured to provide an electrical connection to the pluggable module 102, 102' when received in the cage chamber 101. Said at least one connector 105 can be positioned at a back end 107 of the cage chamber 101 opposite the front side 103. The cage assembly 100 further comprises a removable wall 106 configured to subdivide said cage chamber 101 into two laterally adjacent sub-chambers 101a, 101b, as shown in Figure 1b. The removable wall 106 can be mounted into the cage chamber 101 (Figure 1b) and can be removed from the cage chamber 101 (Figure 1a). A length of said removable wall 106 can advantageously be shorter than a depth of the cage chamber 101. The cage assembly 100 can be used with and without the removable wall 106 mounted into the cage chamber 101. At least one of said sub-chambers 101a, 101b is configured to receive a pluggable module. It is also possible that both sub-chambers 101a, 101b are configured to receive a pluggable module, as shown in Figure 2b. In an inventive way, the cage assembly 100 comprises means 110 for biasing a pluggable module 102 away from said at least one connector 105 when the pluggable module is inserted into the cage chamber 101, as will be shown further on in Figure 3b. The biasing means 110 can be mounted to a side wall 104 of the cage chamber 101. The cage assembly 100 may include a single biasing means or may include a plurality of biasing means. Preferably, every sub-chamber 101a, 101b which is configured to receive a pluggable module, can include at least one biasing means. The biasing means 110 can for example include a leaf spring configured to exert a biasing force which is transverse to said side wall 104 and which is directed towards the cage chamber 101. Other types of biasing means can be used as well. The biasing means may alternatively be mounted to a different wall than a side wall of the cage chamber.

Fig. 2a and 2b show the example embodiment of Figures 1a and 1b when a pluggable module 102, 102' is received in the cage chamber 101 or in the sub-chambers 101a, 101b when the removable wall 106 is mounted in the cage chamber 101. A pluggable module 102 of the first type can for example be a standard MSA pluggable transceiver module, such as for example an SFP-DD form-factor, or any other known form-factor. The pluggable module 102 can also be a so-called "double-wide" pluggable module, as shown in Figure 2a. A width W of a "double-wide" pluggable optical module 102 is more or less twice the width W of a single-width pluggable optical module 102', such as for example of an SFP-DD form-factor. Such a pluggable module 102, 102' includes at least one board finger 102a, also called a board edge connector or a card edge connector, configured to connect with the connector 105 when received in the cage chamber 101. A "double-wide" pluggable optical module 102 can, but need not, include two board fingers 102a. Dimensions of the cage chamber 101 correspond to the type of pluggable module they are configured to receive and may be defined by for example the MSA standards. In the present example embodiment, dimensions of the cage chamber 101 are such that the cage chamber 101 can receive a "double-wide" pluggable optical module 102, or any other pluggable module of the first type, in absence of the removable wall 106, and such that each of the sub-chambers 101a, 101b can receive a single-width pluggable optical module 102', or any other pluggable module of the second type, when the removable wall 106 is mounted into the cage chamber 101. When a "double-wide" pluggable optical module, or any other pluggable module of the first type, is inserted into the cage chamber 101, the sides of the pluggable module 102 will engage the biasing means 110 and will exert a force on the biasing means against the biasing force and will overcome said biasing force since dimensions of the cage chamber 101 are such that play between the pluggable module and the cage chamber is limited. As a result, the biasing means 110 will compress into a tensioned state and the pluggable module 102 can be inserted until connection is made between the board finger 102a of the pluggable module 102 and the connector 105 of the cage assembly 100. The same happens when a single-width pluggable optical module 102' is inserted into a sub-chamber 101a, 101b when the removable wall 106 is mounted in the cage chamber 101. Play between the pluggable module 102', the removable wall 106 and a side wall 104 of the cage chamber 101 is so limited that the biasing means 110 will compress when the pluggable module 102' engages the biasing means 110. The pluggable module 102' can connect with the connector 105.

Fig. 3a and 3b show the example embodiment of Figures 1a and 1b when a single width pluggable module, or any other pluggable module of the second type is received. The pluggable module cage assembly 100 can be used with a "double-wide" pluggable module, or any other type of pluggable module of the first type, in absence of the removable wall 106, as shown in Figure 2a, with two single-width pluggable modules 102' when the removable wall 106 is mounted into the cage chamber 101, as shown in Figure 2b, or with a single single-width pluggable module 102', or any other pluggable module of the second type, received in one of the sub-chambers 101a, 101b, as shown in Figure 3a. In this case, the removable wall 106 needs to be mounted into the cage chamber 101 to provide EMI shielding to the pluggable module 102' of the second type. If, inadvertently, the removable wall 106 were not mounted into the cage chamber, a user could still insert a pluggable module 102' of the second type into the cage chamber 101 since its width is smaller than an internal width of the cage chamber. However, when the cage assembly 100 further includes a means 110 for biasing away an pluggable module away from the at least one connector 105, it becomes physically impossible to connect a pluggable module 102' of the second type, in particular a single-width pluggable module, to the connector 105 in absence of the removable wall 106, as shown in Figure 3b. Since a width W' of the pluggable module of the second type is substantially smaller than an inner width of the cage chamber 101, there is, in absence of the removable wall 106, no force present which is configured to counteract the biasing force of the biasing means. As a result, the pluggable module will be biased in the direction of the biasing force, for example away from the side wall 104 to which the biasing means 110 may be mounted, and the board finger 102a of the pluggable module 102' will not connect to the connector 105. In this way, a user will be reminded of first mounting the removable wall 106 into the cage chamber 101 before being able to insert a pluggable module 102' of the second type in one of the sub-chambers of the cage assembly. As a result, the cage assembly can always be correctly configured for EMC-compliant operation.

Fig. 4 shows a schematic top view of another example embodiment of a pluggable module cage assembly 200. The pluggable module cage assembly 200 can further comprise means 220 for storing said removable wall 106. Said means 220 may for example include an additional external side wall mounted to a side wall 104 of the cage chamber 101 to provide a slit into which the removable wall 106 can be stored when not mounted into the cage chamber 101. Other embodiments of such means 220 for storing the removable wall 106 are possible as well.

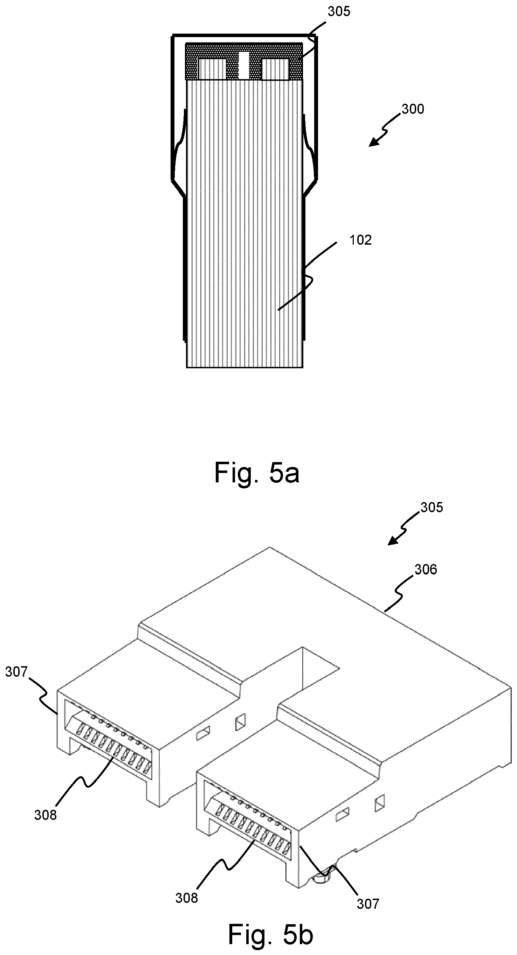

Fig. 5a shows a schematic top view of a further example embodiment of a pluggable module cage assembly including an integral connector 305, of which a perspective view is shown in Fig. 5b. The pluggable module cage assembly 300 may be configured to receive a "double wide" pluggable module 102, as is the case for the cage assembly 100 shown for example in Figure 2a. Both cage assemblies 100, 300 include two connectors 105, each being configured to connect to a pluggable module, in particular, to a board finger 102a of the pluggable module 102. The "double-wide" pluggable module 102 can include two board fingers which are configured to connect to each of the connectors 105 simultaneously. Due to manufacturing tolerances, there may be some variation in distance between the two connectors 105 of the cage assembly 100 shown in Figure 2a. To avoid connection difficulties for "double-wide" pluggable modules having two board fingers, it is advantageous to integrate the two connectors into a single piece 305 which may then be configured to receive two board fingers, either of a "double-wide" pluggable module, or of two single-width pluggable modules. The integrated connector 305 may for example be substantially U-shaped including a joint end 306 configured to join the two connectors. The two ends 307 opposite the joint end 306 can include the connector openings 308 including the electrical connections configured to receive the board fingers 102a of the pluggable module 102.

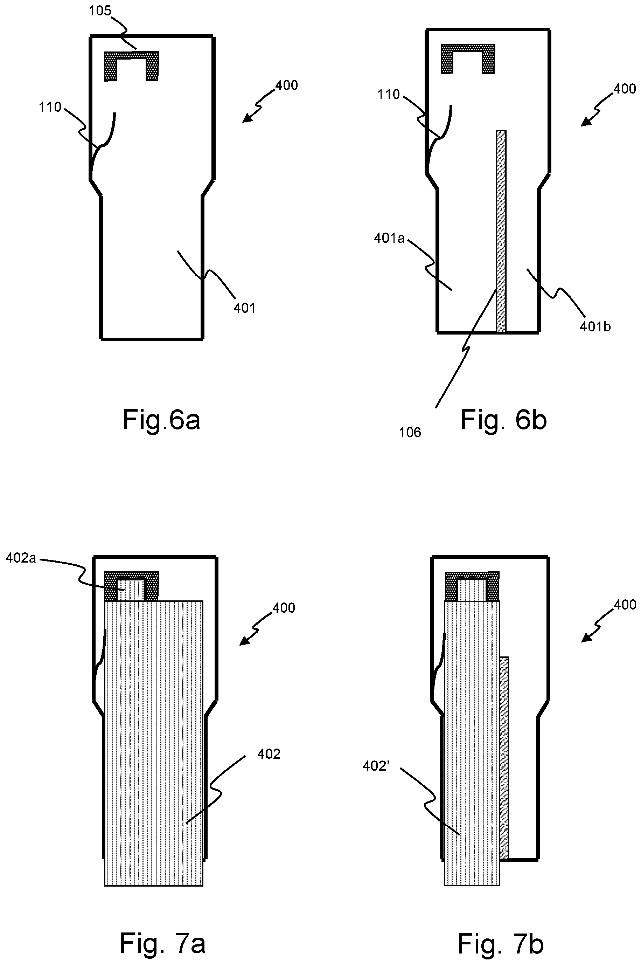

Fig. 6a and 6b show a schematic top view of another example embodiment of a pluggable module cage assembly 400. Fig. 7a and 7b show the example embodiment of Figures 6a and 6b when a pluggable module 402 is received. As described before and shown in previous Figures, the pluggable module cage assemblies 100, 200, 300 are configured to receive a "double wide" pluggable module or any other pluggable module of the first type. However, an internal width of the cage chamber 401 of the cage assembly 400 need not be an integer multiple of a width W of a standard single-width pluggable optical module plus a width of the removable wall. An internal width of the cage chamber 401 can also be larger than a width of a standard single-width pluggable optical module without doubling said width. The cage chamber 401 can then be configured to receive any next-generation pluggable module 402 which may be larger in width than actual standards while the removable wall 106 can provide backward compatibility with actual standards when mounted into the cage chamber 401. A larger next-generation pluggable module 402 can for example provide more space for a larger amount of connections and can increase the surface area for heat transfer. The cage assembly 400 can include only one connector 105 if the next-generation pluggable module 402 only has a single board finger 402a. Dimensions of the cage chamber 401 can be adapted to the needs of future pluggable modules. When the removable wall 106 is mounted into the cage chamber 401 subdividing the cage chamber 401 into two sub-chambers 401a, 401b, only one of said two sub-chambers, for example sub-chamber 401a, may be configured to receive a pluggable module 402, for example a standard single-width pluggable optical module 402', as shown in Figure 7b, to assure backward compatibility with current pluggable modules. The cage assembly 400 may then include a single leaf spring 110 mounted to, or integrated in, one of the side walls 104, in particular to or in the side wall which is part of the sub-chamber 401a configured to receive a pluggable module 402' of the second type, in particular a single-width pluggable optical module, such that the pluggable module of the second type cannot be operatively connected to the connector 105 of the cage assembly 400 in absence of the removable wall 106. Any other type of biasing means can be used instead of a leaf spring. The present example embodiment of the cage assembly can also include means for storing the removable wall 106, as shown in Figure 4.

Fig. 8 shows a perspective top view of a further example embodiment of a pluggable module cage assembly 500. The pluggable module cage assembly 500 can be configured to receive a pluggable module of the first type, in particular a "double wide" pluggable optical module (not shown). When the removable wall (not shown) is mounted into the cage chamber 501, each of the two laterally adjacent sub-chambers may be configured to receive a pluggable module of the second type, for example an SFP-DD pluggable form factor, or any other standard single-width form factor. The cage assembly 500 comprises a cage chamber 501 which is delimited by two side walls 504, a bottom side (see Figure 9), a top side, an open front side 503 and a back wall (see Figure 9). The top side can include a top wall 508 including one or more cutouts through which a heatsink can extend. The removable wall (not shown here) can be mounted into the cage chamber, for example by sliding the wall on a dedicated track 513 extending from an inner side of a bottom wall of the cage chamber. Dimensions of the removable wall, in particular a height of the removable wall, may be chosen such that the removable wall can be held in the cage chamber by friction. Near a front side 503, an exterior side of the cage chamber may include a plurality of finger springs 511 configured to provide EMI shielding between the cage chamber and a gasket or between the cage chamber and a front plate or faceplate. On each of the side walls 504, there is a means 510 for biasing a pluggable module away from the connector (not shown). The biasing means 510 can be a leaf spring, which is embodied here as an inwardly extending and inwardly curved or bent leaf spring. Since both ends of the leaf spring are fixedly attached to an inner side of the side wall 504, part of the leaf spring can form an engagement surface configured to engage a pluggable module and to exert a force or pressure on the pluggable module without damaging the pluggable module or without hindering removal of the pluggable module from the cage assembly 500.

Fig. 9 shows a perspective bottom view of the example embodiment of Fig. 8. The bottom side can include a bottom wall 509 only partially covering a bottom side of the cage chamber 501. The cage assembly 500 can further comprise a base plate (not shown) including a printed circuit board (PCB). When the cage chamber 501 is mounted on the base plate, the open portion of the bottom side of the cage chamber 501 can allow the at least one connector (not shown) to extend into the cage chamber 501. The at least one connector can then provide electrical connection between the connector and the PCB of the base plate, and in fine, when a pluggable module is received in the cage chamber, between the pluggable module and the PCB. The cage assembly 500 can further comprise means for mounting said cage chamber 501 onto said base plate. Said mounting means 512 can include a plurality of pins, for example DPF pins, spaced apart along an outer bottom edge of the cage chamber. The cage assembly 500 can further include an additional pin 514 positioned on a bottom side of said cage chamber 501 but spaced apart from an outer edge of the cage chamber 501. The additional pin 514 is preferably positioned substantially centrally to prevent a bottom side from curving up on the bottom plate. The additional pin 514 may be positioned in line with the removable wall, which does preferably not extend over an entire depth of the cage chamber 501. The top wall 508 can further include a groove 513 configured to receive the removable wall (not shown). In this way, the removable wall can be secured into the cage chamber by friction fit. Other mounting and securing ways are possible as well.

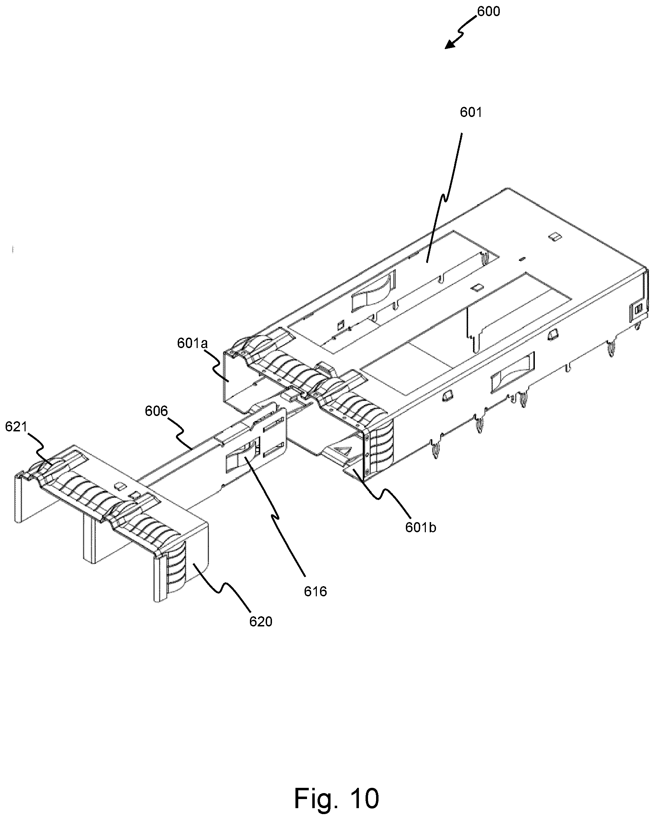

Fig. 10 shows a perspective top view of a further example embodiment of a pluggable module cage assembly 600. The cage assembly 600 can include most features of cage assembly 500 shown in Figures 8 and 9. The difference with previous example embodiments lies in the removable wall 606 which is mounted to a removable inner frame 620. The removable inner frame 620 is configured to be at least partially insertable into the cage chamber 601 and is configured to provide EMI shielding. A depth of the removable inner frame 620 may be substantially shorter than a depth of the cage chamber 601 or than a length of the removable wall 606. The removable wall 606 may be mounted to the removable inner frame 620 in a fixed or releasable way. The removable wall 606 may include at least one additional biasing means 616 configured to centre a pluggable module of the second type when such a pluggable module is inserted into one of the sub-chambers 601a, 601b to ease connection with the connector (not shown). An outer side of the removable inner frame 620 may include further fingers 621 configured to provide EMI shielding.

Although the present invention has been illustrated by reference to specific embodiments, it will be apparent to those skilled in the art that the invention is not limited to the details of the foregoing illustrative embodiments, and that the present invention may be embodied with various changes and modifications without departing from the scope thereof. The present embodiments are therefore to be considered in all respects as illustrative and not restrictive, the scope of the invention being indicated by the appended claims rather than by the foregoing description, and all changes which come within the scope of the claims are therefore intended to be embraced therein.

It will furthermore be understood by the reader of this patent application that the words "comprising" or "comprise" do not exclude other elements or steps, that the words "a" or "an" do not exclude a plurality, and that a single element, such as a computer system, a processor, or another integrated unit may fulfil the functions of several means recited in the claims. Any reference signs in the claims shall not be construed as limiting the respective claims concerned. The terms "first", "second", third", "a", "b", "c", and the like, when used in the description or in the claims are introduced to distinguish between similar elements or steps and are not necessarily describing a sequential or chronological order. Similarly, the terms "top", "bottom", "over", "under", and the like are introduced for descriptive purposes and not necessarily to denote relative positions. It is to be understood that the terms so used are interchangeable under appropriate circumstances and embodiments of the invention are capable of operating according to the present invention in other sequences, or in orientations different from the one(s) described or illustrated above.

## Claims

1. A pluggable module cage assembly for telecommunication and/or data systems, the cage assembly comprising:
- a cage chamber configured to receive a pluggable module of a first type;
- a removable wall configured to subdivide said cage chamber into two laterally adjacent sub-chambers, wherein at least one of said sub-chambers is configured to receive a pluggable module of a second type;
- at least one connector configured to provide an electrical connection to the pluggable module of the first type when received in the cage chamber or to the pluggable module of the second type when received in the at least one of said sub-chambers;
- means for biasing the pluggable module of the second type away from said at least one connector when the pluggable module is inserted into the cage chamber.

2. The pluggable module cage assembly according to claim 1, wherein an internal side wall of said cage chamber includes said biasing means.

3. The pluggable module cage assembly according to any one of the preceding claims, wherein said biasing means includes a leaf spring.

4. The pluggable module cage assembly according to any one of the preceding claims, wherein a length of said removable wall is shorter than a depth of the cage chamber.

5. The pluggable module cage assembly according to any one of the preceding claims, wherein said removable wall is mounted to a removable inner frame.

6. The pluggable module cage assembly according to any one of the preceding claims, wherein dimensions of the removable wall are such that the removable wall is held in the cage chamber by friction.

7. The pluggable module cage assembly according to any one of the preceding claims, further comprising means for storing said removable wall.

8. The pluggable module cage assembly according to any one of the preceding claims, wherein the pluggable module cage assembly is configured to receive a "double wide" pluggable optical module.

9. The pluggable module cage assembly according to any one of the preceding claims, wherein each of said two laterally adjacent sub-chambers are configured to receive a pluggable module.

10. The pluggable module cage assembly according to any one of the preceding claims, comprising at least two connectors.

11. The pluggable module cage assembly according to claim 10, wherein said at least two connectors form an integral piece.

12. The pluggable module cage assembly according to any one of the preceding claims, further comprising means for sensing a presence of the removable wall mounted within the cage chamber.

13. The pluggable module cage assembly according to any one of the preceding claims, further comprising means for mounting said cage chamber onto a base plate, wherein at least one of said mounting means is positioned on a bottom side of said cage chamber spaced apart from an outer edge of the cage chamber.

14. The pluggable module cage assembly according to any of the preceding claims, further comprising a base plate including a printed circuit board (PCB), wherein the pluggable module cage chamber is mounted onto the base plate such that the at least one connector is in electrical connection with the PCB.

15. The pluggable module cage assembly according to claim 14, further comprising a gasket mounted to a front side of the pluggable module cage chamber and configured to minimize EMI.
